# EUROPEAN PATENT APPLICATION

(11) **EP 4 694 654 A1**
(43) Date of publication of application: **11.02.2026**
(21) Application number: 23932164.9
(22) Date of filing: 28.12.2023
(51) Int. Cl.: H10N 30/30, H04R 17/02, H10N 30/01, H10N 30/076, H10N 30/082, H10N 30/50, H10N 30/80, H10N 30/853, H10N 30/87

(54) **PIEZOELECTRIC THIN FILM DEVICE AND MANUFACTURING METHOD FOR SAME**

(30) Priority: 03.04.2023 JP 2023060324
(71) Applicant: DENSO CORPORATION, Kariya-city, Aichi-pref., 448-8661 (JP)
(72) Inventor: KUZUYA, Nobuaki, Kariya-city, Aichi 4488661 (JP); ASHIDA, Youichi, Kariya-city, Aichi 4488661 (JP)
(74) Representative: Kuhnen & Wacker Patent- und Rechtsanwaltsbüro PartG mbB
(86) International application number: PCT/JP2023/047297
(87) International publication number: WO 2024/209756

(57) **Abstract**

The present disclosure is provided with a substrate (10), a lower electrode (13) stacked on the substrate, a piezoelectric film (14) stacked on the lower electrode and composed of a piezoelectric body, and an upper electrode (15) stacked on the piezoelectric film. A thin film portion (17) is formed of the lower electrode, the piezoelectric film, and the upper electrode due to a recess (16) formed in the substrate opposite the lower electrode. An impurity layer (14a) is formed in a surface layer of the piezoelectric film to contain a second element different from the first element, when an element constituting the piezoelectric body is the first element.

## Description

### CROSS REFERENCE TO RELATED APPLICATION

This application is based on Japanese Patent Application No. 2023-060324, filed on April 3, 2023, the contents of which are incorporated herein by reference.

### TECHNICAL FIELD

The present disclosure relates to a piezoelectric thin film device and a manufacturing method for same.

### BACKGROUND ART

A piezoelectric thin film device has a multilayer structure shaped in a cantilever beam, a doubly supported beam, a diaphragm, or the like. For example, there are piezoelectric MEMS (Micro Electro Mechanical Systems) mirrors, BAW (Bulk Acoustic Wave) devices, and piezoelectric MEMS microphones made of a piezoelectric element having a laminated structure of electrodes and a piezoelectric film (for example, Patent Document 1). In the manufacturing process of a piezoelectric element, a lower electrode, a piezoelectric film, and an upper electrode are laminated on the upper surface of a wafer-shaped substrate. A recess is formed in the lower surface of the substrate, and a slit is formed in the laminated structure of the electrodes and the piezoelectric film. Thus, the laminated structure is cantilevered at the end of the substrate to form a vibration region.

### PRIOR ART LITERATURE

### PATENT LITERATURE

Patent Document 1: JP 2022-7879 A

### SUMMARY OF INVENTION

In such devices, it is ideal for the multilayer film to be formed in a flat shape. In reality, however, warping may occur due to stress differences between the films of the multilayer film, and the device may no longer meet standards. For example, in the microphone, when pressure such as sound pressure is applied, the vibration region vibrates and the electric charge generated in the piezoelectric film is output as a detection signal. However, if the vibration region warps, the slit may widen, allowing pressure to escape and narrowing the detection band.

In order to reduce the warping and suppress the decrease in yield and productivity, it is conceivable to control the film stress, for example, by adjusting the film formation conditions. However, the film formation conditions for flattening the multilayer film differ among regions on the wafer surface. Therefore, if the film formation conditions are set so that the multilayer film of the MEMS device formed in a portion of the wafer is flat, the multilayer film will be significantly warped in other regions. It is difficult to reduce the warping of the multilayer film over the entire wafer surface and improve the yield by changing the film formation conditions alone.

An object of the present disclosure is to provide a piezoelectric thin film device capable of improving yield and a method for manufacturing the same.

According to an aspect of the present disclosure, a piezoelectric thin film device includes: a substrate; a lower electrode stacked on the substrate; a piezoelectric film stacked on the lower electrode and made of a piezoelectric body; and an upper electrode stacked on the piezoelectric film. A thin film portion including the lower electrode, the piezoelectric film, and the upper electrode is formed by a recess formed on a surface of the substrate opposite the lower electrode. An element forming the piezoelectric body is a first element. An impurity layer containing, in addition to the first element, a second element different from the first element is formed in the piezoelectric film.

According to this, by forming the impurity layer, the stress difference between the films of the thin film portion can be reduced, and the warping of the thin film portion can be corrected. Compared to formation conditions of a multilayer film, the formation conditions of the impurity layer can be easily set individually for multiple piezoelectric thin film devices on a substrate. The amount of warping correction of the thin film portion can be made to correspond to the amount of warping, by appropriately setting the formation conditions of the impurity layer. Therefore, it is possible to correct the warping of each of the piezoelectric thin film devices formed on a substrate, thereby reducing the variation in the amount of warping to improve the yield.

According to another aspect of the present disclosure, a method of manufacturing a piezoelectric thin film device includes: forming a lower electrode on an upper surface of a substrate; forming a piezoelectric film composed of a piezoelectric body on an upper surface of the lower electrode; forming an upper electrode on an upper surface of the piezoelectric film; forming a recess in the substrate opposite the lower electrode to form a thin film portion including the lower electrode, the piezoelectric film, and the upper electrode; and forming an impurity layer in the piezoelectric film to contain a first element and a second element different from the first element. The first element constitutes the piezoelectric body.

According to this, by forming the impurity layer, the stress difference among the films of the thin film portion can be reduced, and the warping of the thin film portion can be corrected. Compared to the formation conditions of a multilayer film, the formation conditions of the impurity layer can be easily set individually for multiple piezoelectric thin film devices on a substrate. The amount of warping correction of the thin film portion can be made to correspond to the amount of warping, by appropriately setting the formation conditions of the impurity layer. Therefore, it is possible to correct the warping of each of the piezoelectric thin film devices formed on a substrate, thereby reducing the variation in the amount of warping to improve the yield.

It should be noted that the reference numerals in parentheses attached to each component indicate merely one example of correspondence between such components and the specific components described in the embodiments set forth below.

### BRIEF DESCRIPTION OF DRAWINGS

FIG. 1 is a cross-sectional view of a piezoelectric thin film device according to a first embodiment.
FIG. 2 is an enlarged view of an area II in FIG. 1.
FIG. 3A is a cross-sectional view showing a manufacturing process of the piezoelectric thin film device.
FIG. 3B is a cross-sectional view showing a manufacturing process of the piezoelectric thin film device, subsequent to FIG. 3A.
FIG. 3C is a cross-sectional view showing a manufacturing process of the piezoelectric thin film device, subsequent to FIG. 3B.
FIG. 4 is a diagram showing an example of amounts of warping in a wafer.
FIG. 5A is a cross-sectional view showing a manufacturing process of the piezoelectric thin film device, subsequent to FIG. 3B.
FIG. 5B is a cross-sectional view showing a manufacturing process of the piezoelectric thin film device, subsequent to FIG. 5A.
FIG. 5C is a cross-sectional view showing a manufacturing process of the piezoelectric thin film device, subsequent to FIG. 5B.
FIG. 5D is a cross-sectional view showing a manufacturing process of the piezoelectric thin film device, subsequent to FIG. 5C.
FIG. 6 is a diagram showing a scanning of an ion beam.
FIG. 7A is a diagram showing a resist thickness and an ion implantation depth in a region with a small amount of warping.
FIG. 7B is a diagram showing a resist thickness and an ion implantation depth in a region with a medium amount of warping.
FIG. 7C is a diagram showing a resist thickness and an ion implantation depth in a region with a large amount of warping.
FIG. 8A is a diagram showing a distribution of a second element when the acceleration voltage is 20 keV.
FIG. 8B is a diagram showing a distribution of a second element when the acceleration voltage is 60 keV.
FIG. 8C is a diagram showing a distribution of a second element when the acceleration voltage is 100 keV.
FIG. 9 is a diagram showing a relationship between the acceleration voltage and a displacement amount.
FIG. 10 is a cross-sectional view of a piezoelectric thin film device according to a second embodiment.
FIG. 11 is an enlarged view of an area XI in FIG. 10.
FIG. 12A is a cross-sectional view showing a manufacturing process of the piezoelectric thin film device, subsequent to FIG. 5A.
FIG. 12B is a cross-sectional view showing a manufacturing process of the piezoelectric thin film device, subsequent to FIG. 12A.
FIG. 12C is a cross-sectional view showing a manufacturing process of the piezoelectric thin film device, subsequent to FIG. 12B.
FIG. 12D is a cross-sectional view showing a manufacturing process of the piezoelectric thin film device, subsequent to FIG. 12C.
FIG. 13A is a plan view of a piezoelectric thin film device according to a third embodiment.
FIG. 13B is a cross-sectional view taken along line XIIIB-XIIIB in FIG. 13A.
FIG. 14 is a perspective view of the piezoelectric thin film device, with a cross-section taken along line XIV-XIV in FIG. 13.
FIG. 15 is a cross-sectional view showing a warping in a thin film portion during a manufacturing process.
FIG. 16 is a perspective view showing a warping in a thin film portion during a manufacturing process, with a cross-section taken along line XIV-XIV in FIG. 13.
FIG. 17 is a cross-sectional view of a piezoelectric thin film device according to a fourth embodiment.
FIG. 18 is a perspective view of the piezoelectric thin film device shown in FIG. 17.
FIG. 19 is a cross-sectional view showing a warping in a thin film portion during a manufacturing process.

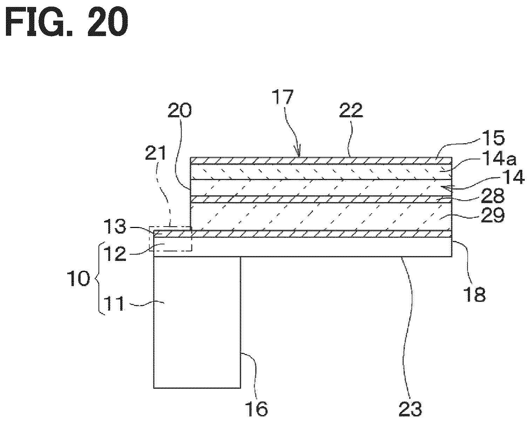

FIG. 20 is a cross-sectional view of a piezoelectric thin film device according to another embodiment.

### DESCRIPTION OF EMBODIMENTS

Hereinafter, embodiments of the present disclosure will be described with reference to the drawings. In the following embodiments, parts that are identical or equivalent to each other are denoted by the same reference numerals.

### (First Embodiment)

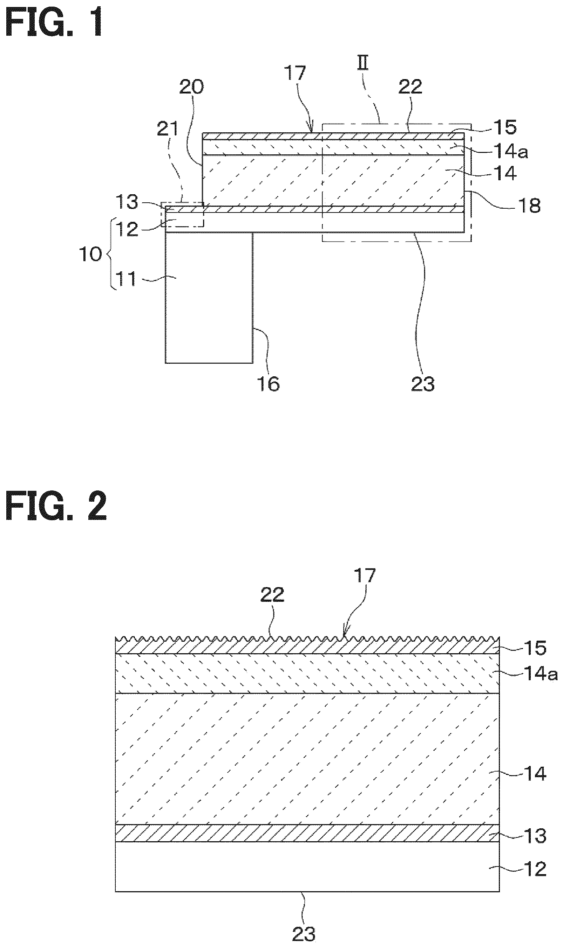

A first embodiment is described below. As shown in FIG. 1, a piezoelectric thin film device of this embodiment includes a semiconductor substrate 10 in which a second substrate 12 is stacked on an upper surface of a first substrate 11. The first substrate 11 and the second substrate 12 are made of, for example, silicon (Si). The first substrate 11 and the second substrate 12 may be bonded directly to each other, or may be bonded to each other via a buried oxide film or the like. For example, when the first substrate 11 and the second substrate 12 are formed using an SOI (Silicon on Insulator) substrate, the first substrate 11 and the second substrate 12 are bonded together via a buried oxide film.

The piezoelectric thin film device includes a lower electrode 13 stacked on the upper surface of the second substrate 12, a piezoelectric film 14 stacked on the upper surface of the lower electrode 13, and an upper electrode 15 stacked on the upper surface of the piezoelectric film 14. The lower electrode 13 and the upper electrode 15 are made of a conductive metal such as molybdenum (Mo). The piezoelectric film 14 is made of a piezoelectric body. For example, the piezoelectric film 14 is made of lead-free piezoelectric ceramics such as barium titanate (BaTiO₃), scandium aluminum nitride (ScAIN), aluminum nitride (AIN), lead zirconate titanate (PZT), or the like. An element constituting the piezoelectric body of the piezoelectric film 14 is referred to as a first element. For example, when the piezoelectric film 14 is made of AIN, the first element is aluminum (AI) and/or nitrogen (N).

A recess 16 is formed on the surface of the semiconductor substrate 10 opposite the lower electrode 13. The recess 16 is formed by removing a portion of the first substrate 11 to expose the lower surface of the second substrate 12 facing the first substrate 11. For example, the recess 16 is a rectangular opening at the lower surface of the semiconductor substrate 10. The first substrate 11 is removed to form the recess 16, thereby thinning a portion of the piezoelectric thin film device. This thinned portion is referred to as a thin film portion 17. In addition, the thin film portion 17 is configured to include at least the lower electrode 13, the piezoelectric film 14, and the upper electrode 15. In this case, the thin film portion 17 includes the second substrate 12, but may be configured to include other films, for example, a protective film formed on the surface.

The laminate of the second substrate 12, the lower electrode 13, the piezoelectric film 14, and the upper electrode 15, including the thin film portion 17, is cantilevered on the first substrate 11 at the end of the recess 16. The side surface 18 of the thin film portion 17 is separated from other portions and exposed.

An impurity layer 14a is formed on the surface layer of the piezoelectric film 14 close to the upper electrode 15. The surface layer of the piezoelectric film 14 does not mean a portion provided separately from the piezoelectric film 14, but rather the portion within the piezoelectric film 14 adjacent to the upper surface of the piezoelectric film 14, i.e., the upper electrode 15, or the portion adjacent to the lower surface of the piezoelectric film 14, i.e., the lower electrode 13. In this embodiment, the impurity layer 14a is formed in the piezoelectric film 14 adjacent to the upper surface of the piezoelectric film 14 as the surface layer of the piezoelectric film 14. The impurity layer 14a is formed in the surface layer of the piezoelectric film 14, but the impurity layer 14a may be formed at any depth in the piezoelectric film 14, within the piezoelectric film 14. However, since forming the impurity layer 14a deep may deteriorate the piezoelectric function of the piezoelectric film 14, it is preferable to form the impurity layer 14a at a position shallower than a depth of half the thickness of the piezoelectric film 14 from the surface of the piezoelectric film 14. The impurity layer 14a is preferably formed at a shallow position in contact with the surface of the piezoelectric film 14 to reduce deterioration of the piezoelectric function, but may be formed at a position away from the surface of the piezoelectric film 14. The impurity layer 14a contains, in addition to the first element which is a constituent element of the piezoelectric film 14, a second element which is different from the first element. The second element is an element that has little effect on the piezoelectric characteristics of the piezoelectric film 14. For example, the second element is phosphorus (P) which is a Group 15 element, boron (B) which is a Group 13 element, magnesium (Mg) which is a Group 2 element, etc., and may include other elements of the same group. The impurity layer 14a contains more voids or amorphous layers than the portion of the piezoelectric film 14 other than the impurity layer 14a.

A recess 20 is formed outside the thin film portion 17 to penetrate the piezoelectric film 14 and the upper electrode 15, such that the upper surface of the lower electrode 13 is exposed. The second substrate 12 and the lower electrode 13 form an outer region 21 located below the recess 20. The second element contained in the impurity layer 14a may be also distributed in the outer region 21.

The thin film portion 17 has a first surface 22 on the same side as the upper electrode 15 with respect to the piezoelectric film 14, and a second surface 23 on the same side as the lower electrode 13 with respect to the piezoelectric film 14. In this embodiment, the upper surface of the upper electrode 15 opposite the piezoelectric film 14 is the first surface 22. The lower surface of the second substrate 12 opposite the lower electrode 13 is the second surface 23. When a protective film or the like is formed on the upper surface of the upper electrode 15, the upper surface of this protective film or the like becomes the first surface 22.

One of the first surface 22 and the second surface 23 closer to the impurity layer 14a has a larger surface roughness than the other of the first surface 22 and the second surface 23. In this embodiment, the impurity layer 14a is formed in the surface layer of the piezoelectric film 14 close to the upper electrode 15. As shown in FIG. 2, the second surface 23 is flat whereas the first surface 22 has projections and recesses. That is, the surface roughness of the first surface 22 is greater than that of the second surface 23.

Such a piezoelectric thin film device can be used, for example, as a microphone. That is, when pressure such as sound pressure is applied to the thin film portion 17, the thin film portion 17 vibrates. A voltage is generated between the lower electrode 13 and the upper electrode 15 due to the deformation of the piezoelectric film 14. By measuring this voltage, pressure such as sound pressure is detected. Although not shown, a part of the lower electrode 13 exposed in the outer region 21 and the upper electrode 15 can be electrically connected to the outside via a bonding wire or the like. The upper electrode 15 may also be extended from the end surface of the piezoelectric film 14 to the surface of the second substrate 12 at a position different from the part from which the lower electrode 13 is extended, so that electrical connection with the outside is made at the surface of the second substrate 12. Even in this case, it is sufficient that the upper electrode 15 is electrically isolated from the lower electrode 13. With this configuration, when a voltage is generated between the lower electrode 13 and the upper electrode 15, the voltage is transmitted to an external measuring device, making it possible to detect pressure such as sound pressure.

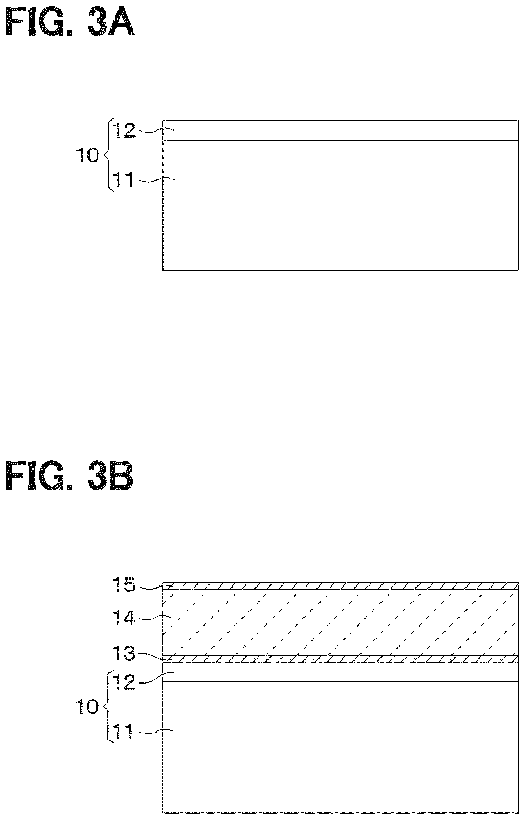

A method for manufacturing the piezoelectric thin film device of this embodiment will be described. In this embodiment, first, a piezoelectric thin film device for measuring the amount of warping, which will be described later, is manufactured. The measurement results of the amount of warping are then used to manufacture the piezoelectric thin film device that will become a product. The piezoelectric thin film device for measuring the amount of warping is manufactured by carrying out the steps shown in FIGS. 3A to 3C using a semiconductor manufacturing apparatus.

In the step shown in FIG. 3A, a wafer-like semiconductor substrate 10 having a structure in which a first substrate 11 and a second substrate 12 are bonded together is prepared. After the first substrate 11 is prepared, the second substrate 12 may be laminated on the surface of the first substrate 11. Plural piezoelectric thin film devices are formed on the semiconductor substrate 10. FIGS. 3A to 3C show an area corresponding to one of the piezoelectric thin film devices.

In the step shown in FIG. 3B, the lower electrode 13, the piezoelectric film 14, and the upper electrode 15 are laminated in this order on the upper surface of the second substrate 12. That is, the lower electrode 13 is formed on the upper surface of the second substrate 12. The piezoelectric film 14 is formed on the upper surface of the lower electrode 13. The upper electrode 15 is formed on the upper surface of the piezoelectric film 14. The lower electrode 13, the piezoelectric film 14, and the upper electrode 15 are formed by a general sputtering method, a CVD (Chemical Vapor Deposition) method, or the like.

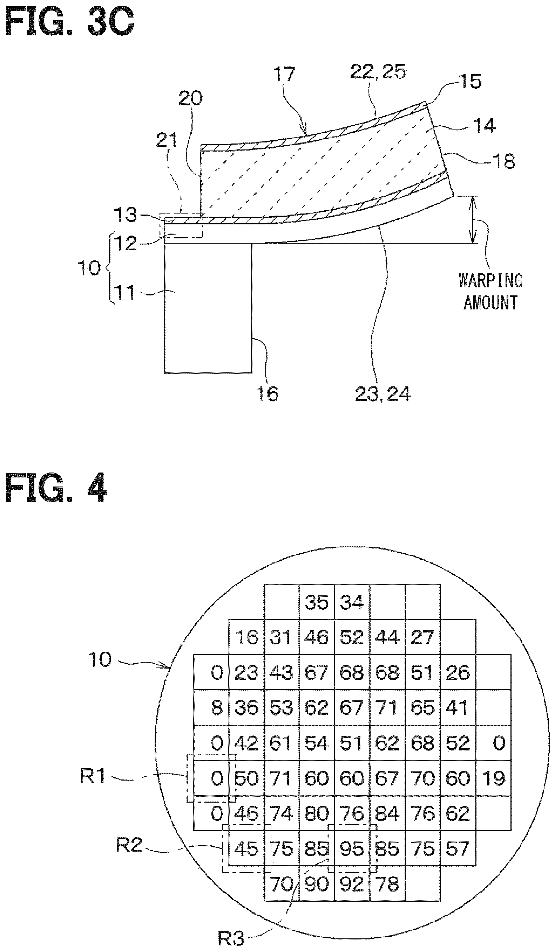

In the step shown in FIG. 3C, the thin film portion 17 is formed. Specifically, the second substrate 12, the lower electrode 13, the piezoelectric film 14, and the upper electrode 15 are partially removed by etching using a mask (not shown) to form the side surface 18. The recess 20 is formed by removing the piezoelectric film 14 and the upper electrode 15, outside the region that will become the thin film portion 17. Thereafter, a resist (not shown) is formed on the upper surface of the lower electrode 13 exposed from the recess 20, the upper surface of the upper electrode 15, and further on the lower surface of the first substrate 11 in a portion where the recess 16 is not to be formed. Then, a portion of the first substrate 11 is removed by etching using this resist as a protective film to form the recess 16. As a result, the thin film portion 17 is formed as cantilevered on the first substrate 11. After the thin film portion 17 is formed, the resist (not shown) is peeled off.

When the recess 16 is formed, a warping occurs in the thin film portion 17 due to a stress difference among the films of the thin film portion 17. The thin film portion 17 has a convex surface 24 that is convex toward the outside, and a concave surface 25 that is concave toward the opposite side to the convex surface 24. In this embodiment, the second surface 23, which is a lower surface of the thin film portion 17, is the convex surface 24. The first surface 22, which is an upper surface, is the concave surface 25. In other words, the free end of the thin film portion 17 is displaced upward due to deformation of the thin film portion 17.

In the step shown in FIG. 3C, plural thin film portions 17 are formed so that plural piezoelectric thin film devices are formed on the wafer-like semiconductor substrate 10.

After the step shown in FIG. 3C, the amount of warping of the thin film portion 17 is measured. The amount of warping of thin film portion 17 is measured by measuring the height of the tip of the second surface 23 from the upper surface of the first substrate 11, as shown in FIG. 3C. The measurement result is, for example, as shown in FIG. 4 showing the results of dividing the semiconductor substrate 10 into plural rectangular regions and measuring the amount of warping of one thin film portion 17 selected from each region. The amount of warping is measured in unit of µm. FIG. 4 shows the results of measurement of the amount of warping in experiments conducted by the present inventors. In the areas without values, the amount of warping was not measured during the experiments.

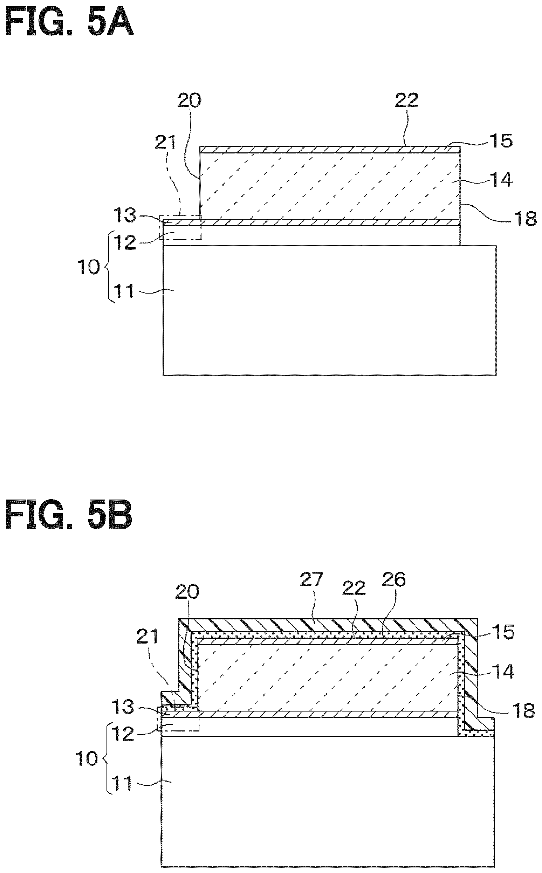

After the amount of warping is measured in this manner, the piezoelectric thin film device that will become a product is manufactured. The piezoelectric thin film device that will become a product is manufactured by carrying out the steps shown in FIGS. 3A and 3B in the same manner as the piezoelectric thin film device for measuring the amount of warping, and then carrying out steps shown in FIGS. 5A to 5D. In the manufacture of the piezoelectric thin film device that will become a product, the film formation conditions in the step shown in FIG. 3B are set to be the same as those in the manufacture of the piezoelectric thin film device for measuring the amount of warping.

In the step shown in FIG. 5A, the side surface 18 and the recess 20 are formed. Specifically, the second substrate 12, the lower electrode 13, the piezoelectric film 14, and the upper electrode 15 are partially removed by etching using a mask (not shown) to form the side surface 18. The recess 20 is formed by removing the piezoelectric film 14 and the upper electrode 15, outside the region that will become the thin film portion 17.

Since the film formation conditions in the step shown in FIG. 3B are set as described above, a stress difference similar to that in the piezoelectric thin film device for measuring the amount of warping occurs in the second substrate 12 to the upper electrode 15 in the region to be the thin film portion 17. That is, when the recess 16 is formed immediately after the step shown in FIG. 5A, the thin film portion 17 is deformed so that the first surface 22 becomes the concave surface 25 and that the second surface 23 becomes the convex surface 24. In this case, the warping of the thin film portion 17 in each piezoelectric thin film device on the semiconductor substrate 10 tends to be the same as the distribution shown in FIG. 4.

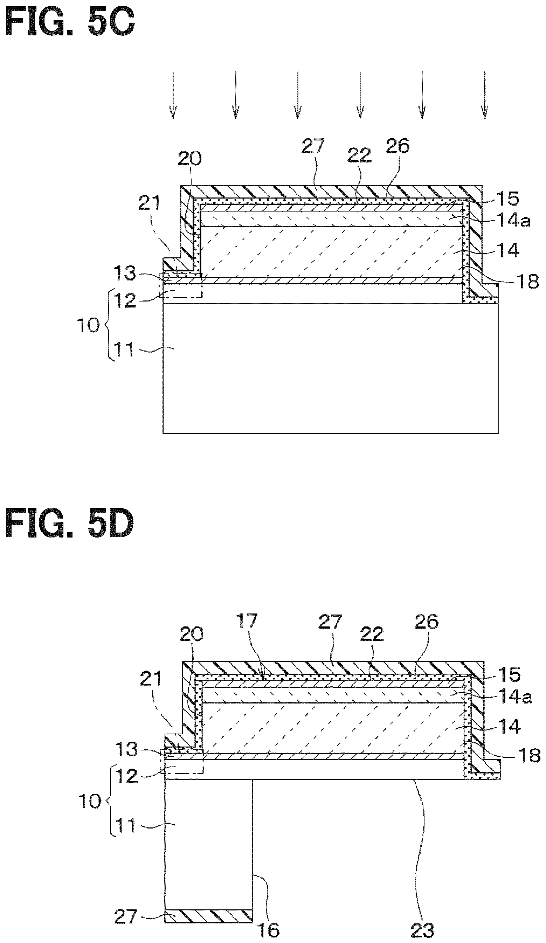

In the step shown in FIG. 5B, a silicon oxide film is formed on the upper surface of the lower electrode 13 exposed from the recess 20 and on the upper surface of the upper electrode 15. The silicon oxide film serves as a through film 26 for ion implantation performed in the step shown in FIG. 5C. Furthermore, a resist 27 is applied onto the through film 26. Alternatively, the through film 26 may not be formed, and the resist 27 may be applied to the upper surfaces of the lower electrode 13 and the upper electrode 15.

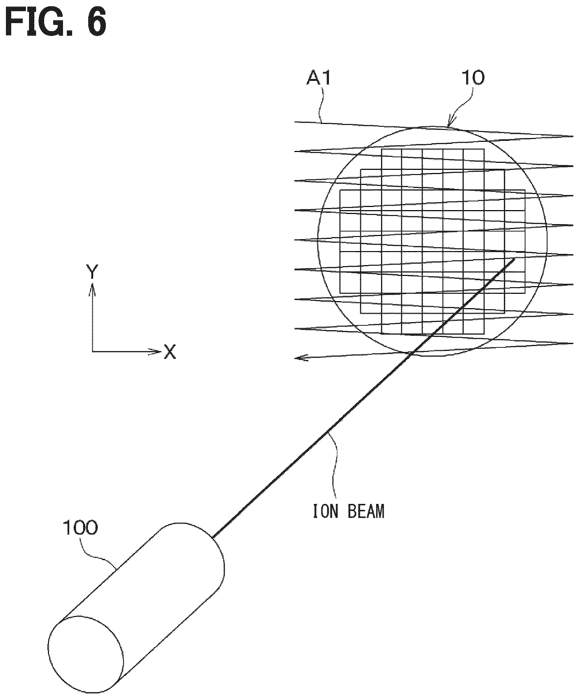

In the step shown in FIG. 5C, a second element different from the first element is added to a surface layer of the piezoelectric film 14 close to the first surface 22 to be the concave surface 25 in the step shown in FIG. 3C to form the impurity layer 14a. Specifically, the ionized second element is accelerated by a voltage in a vacuum and injected into the piezoelectric film 14 from the first surface 22. As shown in FIG. 6, the second element is implanted by scanning an ion beam emitted from an ion implantation device 100 in the X direction and the Y directions as indicated by an arrow A1 to irradiate each piezoelectric thin film device on the semiconductor substrate 10. The X direction is parallel to the upper surface of the semiconductor substrate 10. The Y direction is parallel to the upper surface of the semiconductor substrate 10 and perpendicular to the X direction.

In the step shown in FIG. 5D, a portion of the first substrate 11 is removed by etching using the resist 27 as a protective film to form the recess 16. At this time, the resist 27 is formed not only on the portion formed in the step shown in FIG. 5B but also on the portion of the lower surface of the first substrate 11 where the recess 16 is not to be formed. The thickness of the resist 27 formed on the lower surface of the first substrate 11 may be set regardless of the step shown in FIG. 5C, so as to withstand etching of the recess 16. As a result, during etching, the first substrate 11 is removed in the area where the resist 27 is absent, and the recess 16 is formed. As a result, the thin film portion 17 is formed as cantilevered on the first substrate 11. After the thin film portion 17 is formed, the through film 26 and the resist 27 are peeled off, and the wafer-like semiconductor substrate 10 is divided into chip units, thereby forming the piezoelectric thin film device shown in FIG. 1. The width of each chip is, for example, several mm to several tens of mm.

When ions are implanted in this manner, the bonds within the crystal lattice of the piezoelectric film 14 are broken, and a compressive stress is applied to the thin film portion 17 adjacent to the first surface 22. This reduces the stress difference among the films of the thin film portion 17, and the thin film portion 17 approaches an ideal shape, that is, a flat shape, as shown in FIG. 1. The polycrystalline structure of the piezoelectric film 14 is destroyed by ion implantation, and voids and amorphous layers are formed. Therefore, the impurity layer 14a has more voids and/or more amorphous layers than other portions of the piezoelectric film 14. Furthermore, the concave surface 25 is damaged by the ion implantation, forming irregularities, so that the surface roughness of the first surface 22 is greater than that of the second surface 23.

The thickness of the resist 27 is adjusted in accordance with the amount of warping of the thin film portion 17 measured after the step shown in FIG. 3C. Specifically, the thickness of the resist 27 over the entire wafer is adjusted so that the smaller the amount of warping of the thin film portion 17, the thicker the resist 27 becomes, and the larger the amount of warping, the thinner the resist 27 becomes. As a result, the amount of ions implanted into the thin film portion 17 increases in a portion with a larger amount of warping, and the amount of warping correction increases. The thickness of the resist 27 is controlled by the amount of exposure light from the exposure device. The exposure device may be, for example, a stepper.

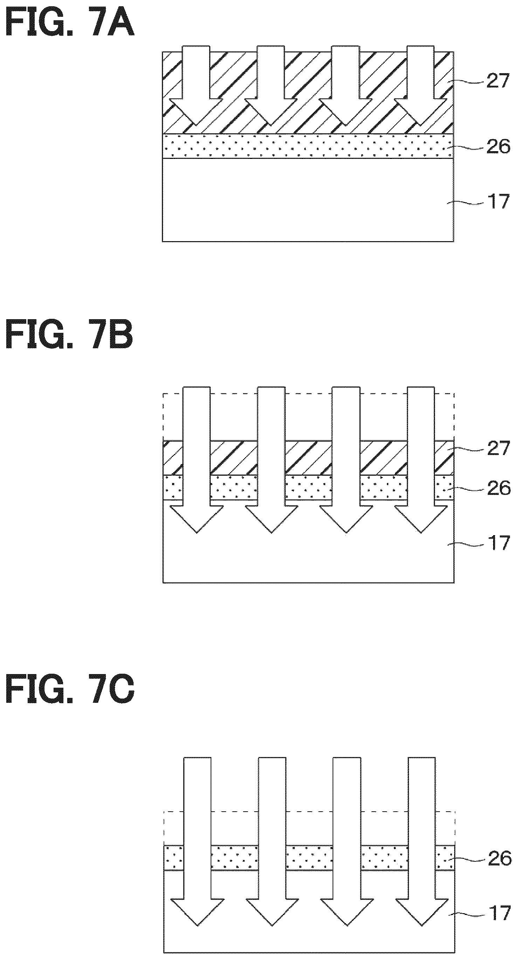

For example, in a region R1 of FIG. 4 where the amount of warping is small, the amount of exposure of the resist 27 is reduced and the resist 27 is left thick, as shown in FIG. 7A. As a result, as indicated by blank arrows, the implanted ions are absorbed by the resist 27 and are less likely to reach the through film 26 and the thin film portion 17.

In a region R2 of FIG. 4 having a larger amount of warping than the region R1, as shown in FIG. 7B, the resist 27 is exposed to a larger amount of light and is made thinner than the resist 27 in the region R1. The dashed line in FIG. 7B indicates the thickness of the resist 27 in the region R1. This allows the implanted ions to pass through the resist 27 and the through film 26 and reach the thin film portion 17, as indicated by blank arrows.

In a region R3 of FIG. 4 having a larger amount of warping than the region R2, the amount of exposure of the resist 27 is further increased. As shown in FIG. 7C, the resist 27 is removed to expose the upper surface of the through film 26. The dashed line in FIG. 7C indicates the thickness of the resist 27 in the region R2. This allows the implanted ions to reach the thin film portion 17 more easily, as indicated by blank arrows. Moreover, the implanted ions reach a deep portion of the thin film portion 17.

In this way, by making the resist 27 sufficiently thick in the area where the amount of warping is small, the ion implantation into the thin film portion 17 is suppressed. Thus, the ion implantation can be performed only in the area where the expected warping correction is required. The warping may be corrected by ion implantation only in the region where the amount of warping exceeds a reference value. The thickness of the resist 27 may be adjusted using a pattern such as a gray-tone mask. For example, when the resist 27 is exposed by an exposure device, the amount of exposure is adjusted according to the thickness of the resist 27 that is desired to be set for each shot. Specifically, in shots at locations where correction is required, the resist 27 is made thin and the exposure amount is increased so that ions can reach the thin film portion 17. In shots at locations where correction is not required, the resist 27 is made thick and the exposure amount is decreased so that ion implantation does not reach the thin film portion 17. When a pattern such as a gray-tone mask is used, a gray-tone mask corresponding to the thickness of the resist 27 to be set may be selected to give a gradient to the amount of exposure light.

The amount of warpage correction varies depending on the thickness of the resist 27 as well as the acceleration voltage of the ion implantation and the type of the second element.

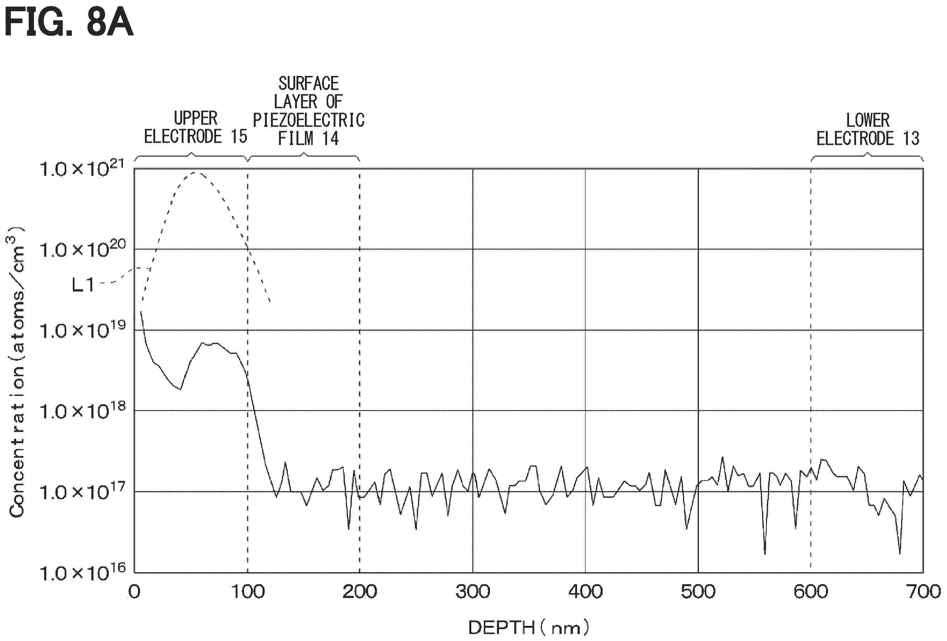

Specifically, the higher the acceleration voltage, the greater the amount of warping correction. FIGS. 8A to 8C show relationships between a depth from the first surface 22 and a concentration of the second element when phosphorus is used as the second element. FIGS. 8A to 8C are graphs when the acceleration voltages are 20 keV, 60 keV, and 100 keV, respectively. The dose of phosphorus is set to 1x10¹³ /cm².

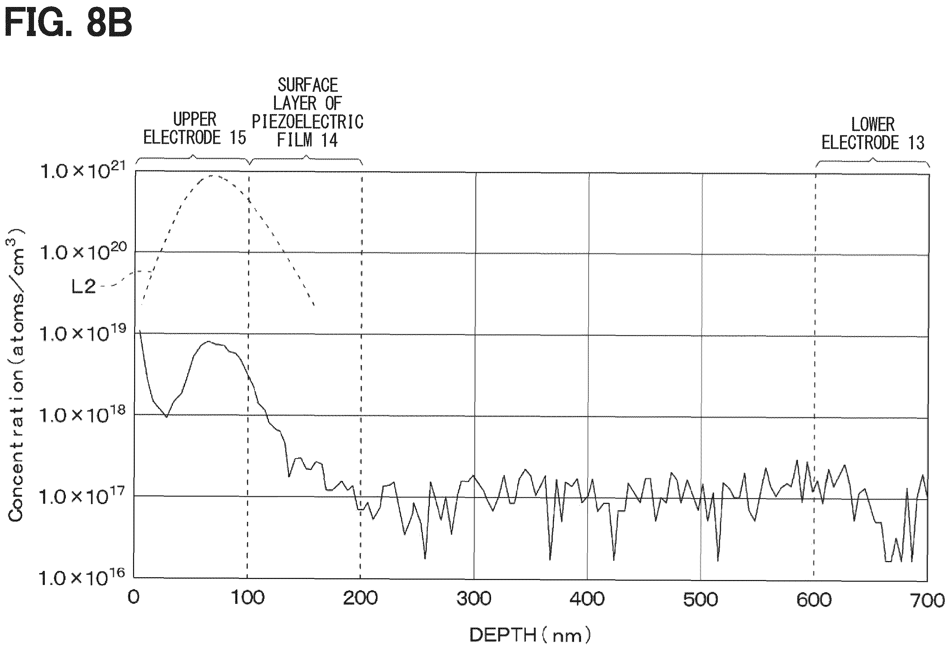

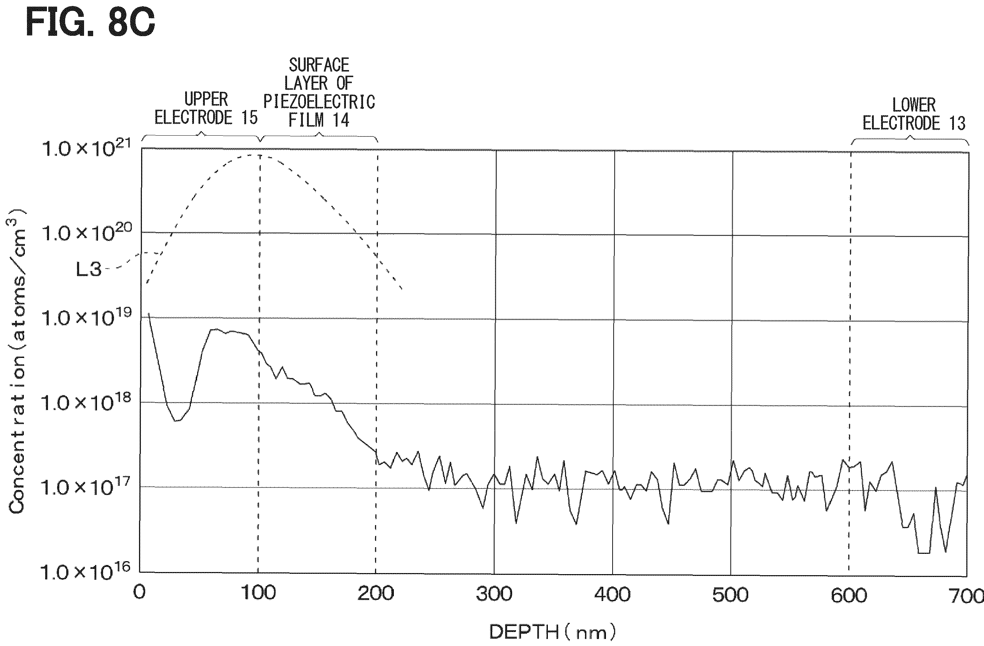

As shown in FIGS. 8A to 8C, the higher the acceleration voltage, the deeper the second element is implanted. That is, when the acceleration voltage is 20 keV, the phosphorus concentration in the piezoelectric film 14 is almost zero as shown in FIG. 8A. When the acceleration voltage is 60 keV, phosphorus diffuses into the surface layer of the piezoelectric film 14 as shown in FIG. 8B. When the acceleration voltage is 100 keV, phosphorus diffuses to an even deeper location, specifically, to a depth of 200 nm from the surface of the upper electrode 15 as shown in FIG. 8C.

In each of FIGS. 8A to 8C, a drop in concentration is seen in the surface layer of the upper electrode 15, but this data is considered to be noise. That is, the positions of the concentration peaks in FIGS. 8A to 8C are considered to be as indicated by dashed lines L1, L2, L3, respectively. When the acceleration voltage is 20 keV, the concentration peak position is in the middle layer of the upper electrode 15. When the acceleration voltage is 60 keV, the concentration peak position is located deeper than the middle layer of the upper electrode 15. When the acceleration voltage is 100 keV, the concentration peak is located near the interface between the upper electrode 15 and the piezoelectric film 14.

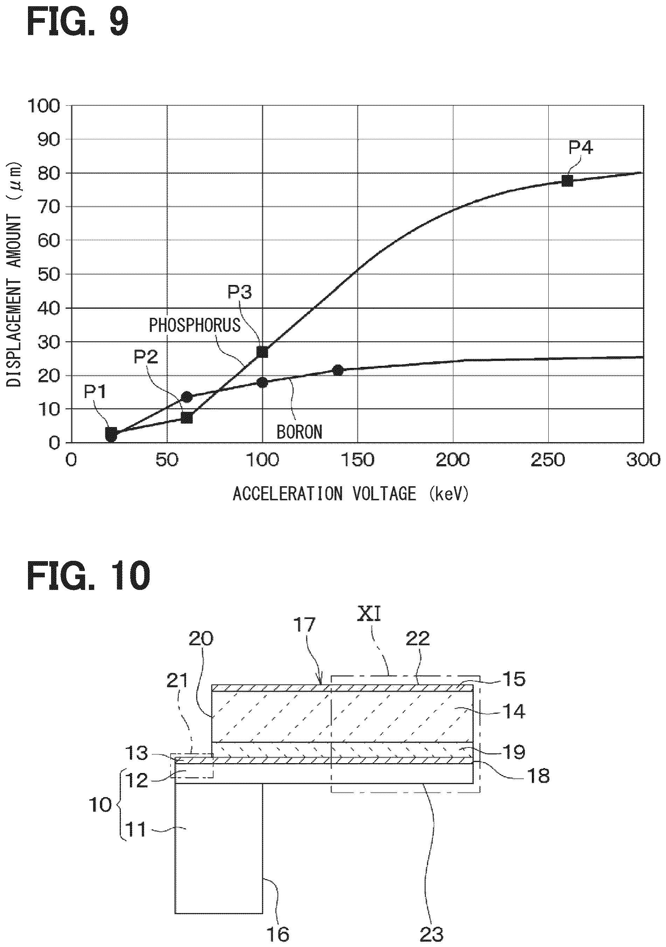

FIG. 9 is a graph showing a relationship between an acceleration voltage and a displacement amount of the thin film portion 17 due to ion implantation, that is, the correction amount of the warping. FIG. 9 shows the measurement results of the displacement amount when phosphorus is selected as the second element and when boron is selected as the second element. In FIG. 9, the doses of phosphorus and boron are both set to 1x10¹³ /cm².

When phosphorus is used, as shown in FIGS. 8A to 8C and FIG. 9, the concentration peak position of the second element becomes deeper as the acceleration voltage increases, and the correction amount of warping increases. FIGS. 8A to 8C correspond to plots P1 to P3 in FIG. 9. In plot P4 where the acceleration voltage is 260 keV, the concentration peak position is deeper than that in the distribution of FIG. 8C, and the concentration peak position is in a deep layer of the piezoelectric film 14.

Similarly, when boron is used, the higher the acceleration voltage, the deeper the concentration peak position of the second element becomes, and the greater the correction amount of warping becomes. When boron is used, the concentration peak reaches the piezoelectric film 14 at an acceleration voltage of 60 keV, and the concentration peak reaches a deep portion of the piezoelectric film 14 at an acceleration voltage of 140 keV.

Therefore, in a portion where the warping is large, the correction amount of the warping increases by increasing the acceleration voltage, and the thin film portion 17 approaches a flat shape.

As shown in FIG. 9, when the acceleration voltage becomes large to a certain extent, the correction amount changes in proportion to the acceleration voltage, making it easy to control the correction amount. As the acceleration voltage increases further, the change in the correction amount relative to the change in the acceleration voltage decreases. According to the study by the present inventors, at an acceleration voltage at which the concentration peak reaches the piezoelectric film 14, the change in the correction amount becomes small. In the portion where the change in the amount of correction is small, the amount of correction can be controlled more easily.

Furthermore, as shown in FIG. 9, when phosphorus is used, the correction amount is larger than when boron is used, in case where the acceleration voltage is 100 keV or higher. Therefore, when the amount of warping of the thin film portion 17 is large, it becomes easier to make the thin film portion 17 closer to a flat shape by using an element such as phosphorus that has a large amount of correction as the second element. On the other hand, when the amount of warping of the thin film portion 17 is small, there is no need to increase the amount of correction, so it is desirable to use an element such as boron, which has a small change in the amount of correction relative to a change in acceleration voltage, as the second element to improve the controllability of the warping correction. As shown in FIG. 9, when boron is used as the second element, the change in the correction amount becomes small after 60 keV at which the concentration peak reaches the piezoelectric film 14. Therefore, it is desirable to set the acceleration voltage within this range to improve the controllability of the warping correction.

Furthermore, according to the study by the present inventors, by setting the ion implantation conditions as follows, it is possible to efficiently correct the warping of the thin film portion 17 while suppressing damage to the concave surface 25. That is, the dose is set to 1x10¹⁵ /cm² or less, and the acceleration voltage is set to 20 keV or more and 200 keV or less. The second element is used, which has a small effect on the piezoelectric properties of the piezoelectric film 14 and a large atomic weight. For example, phosphorus, boron, magnesium, or the like is used as the second element. In addition, the spot diameter of the ion beam is made larger than the element size of the piezoelectric thin film device so that the ion beam is uniformly irradiated onto the entire element.

By making the spot diameter of the ion beam larger than the width of the thin film portion 17, ions are also implanted into the outer region 21. However, since the second substrate 12 and the lower electrode 13 on the first substrate 11 have a strength greater than that of the thin film portion 17, the thin film portion 17 is corrected more preferentially than the outer region 21 by appropriately setting the ion implantation conditions.

As described above, in this embodiment, the impurity layer 14a is formed in the surface layer of the piezoelectric film 14, and contains the second element different from the first element, which is a constituent element of the piezoelectric film 14, in addition to the first element. This makes it possible to reduce the stress difference among the films of the thin film portion 17 and correct the warping of the thin film portion 17. By appropriately setting conditions such as the thickness of the resist 27, the acceleration voltage, and the type of the second element when forming the impurity layer 14a, the amount of correction for the warping of the thin film portion 17 can be made to correspond to the amount of warping. Moreover, these conditions can be easily set individually for plural piezoelectric thin film devices formed on the wafer-like semiconductor substrate 10. For example, the thickness of the resist 27 on each piezoelectric thin film device can be adjusted by the amount of exposure light, and the acceleration voltage can be changed during scanning of the ion beam. Therefore, the warping of plural piezoelectric thin film devices can be individually corrected to reduce the variation in the amount of warping, thereby improving the yield.

According to this embodiment, it is possible to achieve the following advantageous effects.

(1) The impurity layer 14a contains more voids or amorphous layers than the other portions of the piezoelectric film 14 that are not the impurity layer 14a. By implanting ions, part of the crystal structure of the piezoelectric film 14 is destroyed and voids and an amorphous layer are formed, whereby the bonds within the crystal lattice of the piezoelectric film 14 are cut and compressive stress is applied to the thin film portion 17 adjacent to the first surface 22. This makes it possible to correct the warping of the thin film portion 17.
(2) One of the first surface 22 and the second surface 23 closer to the impurity layer 14a has a larger surface roughness than the other of the first surface 22 and the second surface 23. By implanting ions from the first surface 22, the impurity layer 14a is formed in the surface layer of the piezoelectric film 14 close to the first surface 22, and the warping of the thin film portion 17 is corrected. At this time, the first surface 22 is damaged, and the surface roughness of the first surface 22 becomes greater than that of the second surface 23.
(3) The impurity layer 14a is formed in the surface layer of the piezoelectric film 14 close to the first surface 22 to be the concave surface 25 when the thin film portion 17 warps. According to this, a compressive stress is applied to the thin film portion 17 adjacent to the first surface 22, and the stress difference among the films of the thin film portion 17 is reduced, so that the thin film portion 17 approaches a flat shape.
(4) The second element is selected depending on the degree of warping of the thin film portion 17. According to this, by appropriately selecting the second element, it is possible to increase the amount of correction and improve the controllability of the correction.
(5) The ionized second element is accelerated by voltage and injected into the piezoelectric film 14. By such ion implantation, the warping of the thin film portion 17 can be corrected.
(6) The thickness of the resist 27 is changed depending on the location in accordance with the degree of warping of the thin film portion 17, and the second element is introduced into the piezoelectric film 14 using the resist 27. This makes it possible to adjust the amount of correction according to the amount of warping of each thin film portion 17.
(7) The thickness of the resist 27 is controlled by an exposure device. According to this, the thickness of the resist 27 can be changed depending on the location, and the amount of correction can be adjusted according to the amount of warping of each thin film portion 17.

### (Second Embodiment)

A second embodiment will be described. In this embodiment, the position of the impurity layer 14a is changed from that of the first embodiment, and other points are the same as those in the first embodiment, so only the points different from the first embodiment will be described.

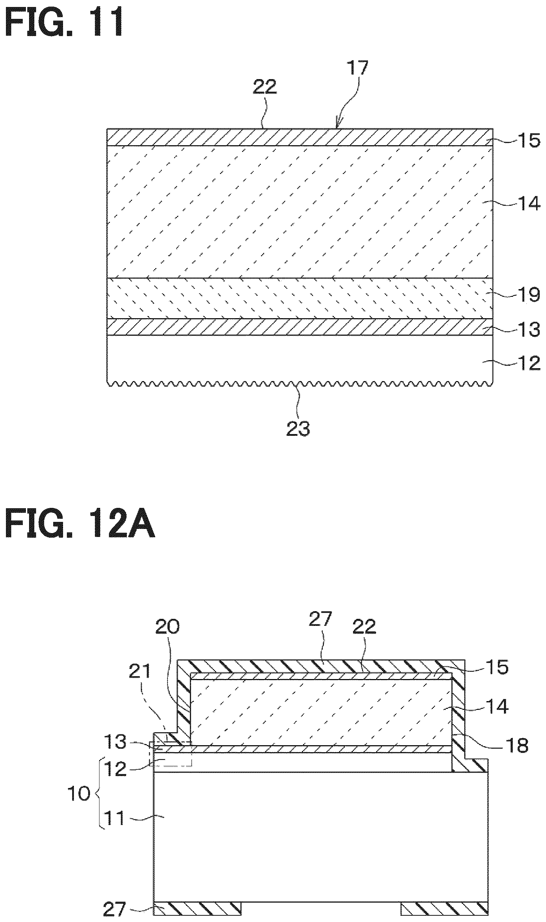

As shown in FIG. 10, in this embodiment, the impurity layer 14a is formed adjacent to the second surface 23 of the piezoelectric film 14, in other words, on the surface layer close to the lower electrode 13. As shown in FIG. 11, the first surface 22 is flat, whereas the second surface 23 has projections and recesses. That is, the second surface 23 has a greater surface roughness than the first surface 22.

In this embodiment, the piezoelectric thin film device is manufactured by carrying out the steps shown in FIGS. 12A to 12D after the steps shown in FIGS. 3A, 3B, and 5A. In the step shown in FIG. 3B, the film formation conditions for the lower electrode 13, the piezoelectric film 14, and the upper electrode 15 are set so that the thin film portion 17 becomes upwardly convex due to the formation of the recess 16.

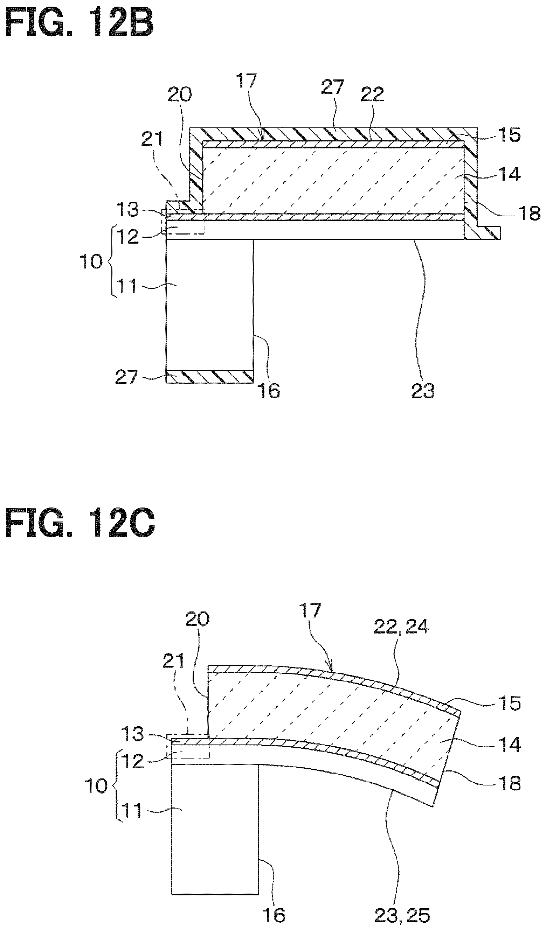

In the step shown in FIG. 12A, the resist 27 is applied to the upper surface of the lower electrode 13 exposed from the recess 20, the upper surface of the upper electrode 15, and further to the lower surface of the first substrate 11 in a portion where the recess 16 is not to be formed. In the step shown in FIG. 12B, a portion of the first substrate 11 is removed by etching using the resist 27 as a protective film to form the recess 16.

In the step shown in FIG. 12C, the resist 27 is removed. Since the film formation conditions in the step shown in FIG. 3B are set as described above, the peeling of the resist 27 causes the thin film portion 17 to deform so as to become upwardly convex. That is, the free end of the thin film portion 17 is displaced downward. The first surface 22, which is an upper surface of the thin film portion 17, becomes the convex surface 24. The second surface 23, which is a lower surface of the thin film portion 17, becomes the concave surface 25.

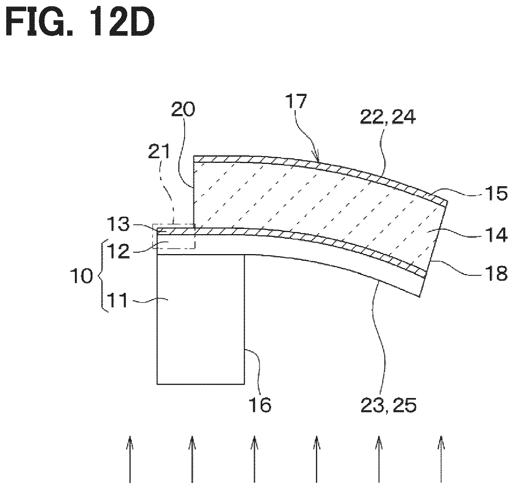

In the step shown in FIG. 12D, ions are implanted from the lower surface of the semiconductor substrate 10. As a result, as shown in FIG. 10, an impurity layer 14a is formed in the surface layer of the piezoelectric film 14 close to the second surface 23, and the warping of the thin film portion 17 is corrected. In this embodiment, the amount of warping is measured after the step shown in FIG. 12C, and the amount of correction is adjusted depending on the measurement result by the acceleration voltage and the type of the second element.

If it is desired to reduce the surface roughness of the upper electrode 15, the film formation conditions can be adjusted so that the free end of the thin film portion 17 is displaced downward. The ions can be implanted from the underside to correct the warping, thereby suppressing an increase in the surface roughness of the upper electrode 15.

The present embodiment can achieve the same effects as those of the first embodiment from the same configuration and operation as those of the first embodiment.

### (Third Embodiment)

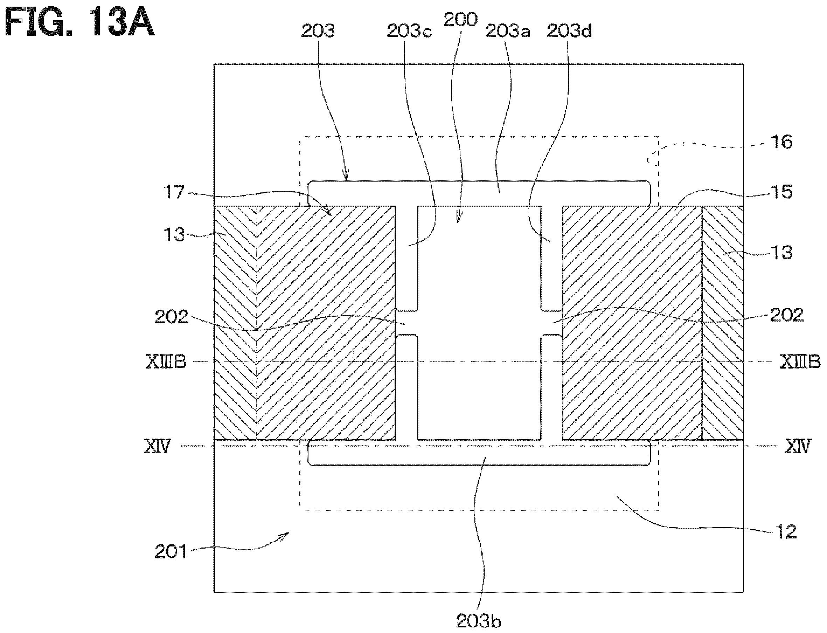

A third embodiment will be described, in which the present disclosure is applied to a piezoelectric MEMS mirror having a structure in which a piezoelectric thin film device is supported at both ends through support beam. The basic structure of the piezoelectric thin film device of this embodiment is similar to that of the piezoelectric thin film device described in the first embodiment, so differences from the first embodiment will be mainly described. The piezoelectric thin film device of this embodiment will be described below with reference to FIGS. 13A, 13B, and 14 to 16. To make FIGS. 13A, 14, and 16 easier to see, the lower electrode 13, the piezoelectric film 14, and the upper electrode 15 are hatched.

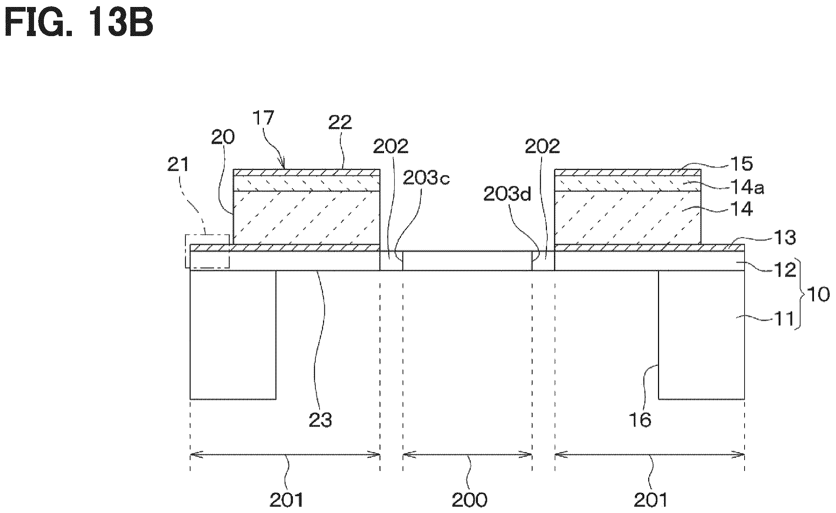

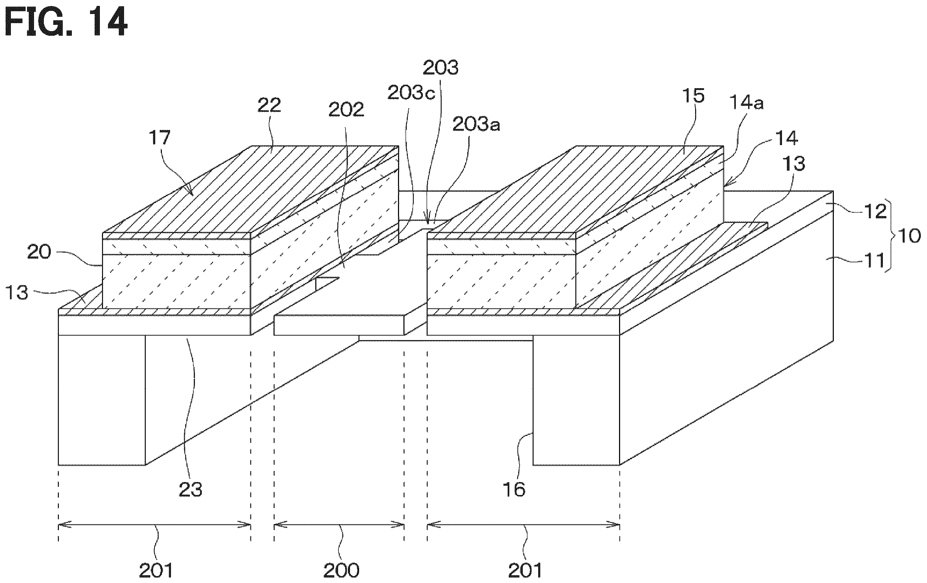

The piezoelectric thin film device shown in FIGS. 13A, 13B, and 14 forms a piezoelectric MEMS mirror. The piezoelectric thin film device has a structure in which the outer edge of the thin film portion 17 is supported by the first substrate 11 that is shaped like a rectangular frame having the recess 16. The thin film portion 17 has a mirror portion 200, a peripheral portion 201 arranged around the mirror portion 200, and a support portion 202 connecting the mirror portion 200 and the peripheral portion 201. The mirror portion 200 is supported at both ends by the peripheral portion 201 through the support portion 202. The peripheral portion 201 refers to the portions of the second substrate 12, the lower electrode 13, the piezoelectric film 14 and the upper electrode 15 located outside the mirror portion 200 and the support portion 202, and also includes a portion located outside the thin film portion 17.

Specifically, as shown in FIG. 13B, the thinned second substrate 12 is stacked on the first substrate 11, and the recess 16 is formed in the inner portion of the first substrate 11 excluding the outer edge portion. The mirror portion 200 is provided, for example, at the center position of the portion where the recess 16 is formed. The peripheral portion 201 is disposed to surround the mirror portion 200. The lower electrode 13, the piezoelectric film 14 and the upper electrode 15 are stacked in this order on the surface of the second substrate 12, in a part of the peripheral portion 201. The impurity layer 14a containing the second element in addition to the first element is formed on the surface layer of the piezoelectric film 14 adjacent to the upper electrode 15. Then, as shown in FIG. 13A, in the portion where the recess 16 is formed, the second substrate 12 is patterned to form a slit 203. The slit 203 separates the mirror portion 200 from the peripheral portion 201 and also constitutes the support portion 202 that connects the mirror portion 200 and the peripheral portion 201.

More specifically, the slit 203 has two extension portions 203a, 203b extending parallel to each other in one direction which is left-right direction of the paper in FIG. 13A, and two extension portions 203c, 203d extending parallel to each other in another direction which is up-down direction perpendicular to the left-right direction. The extension portion 203c, 203d is separated at a middle position, and the separated portion constitutes the support portion 202. Moreover, the extension portion 203a, 203b extends beyond the mirror portion 200 to the outside. The mirror portion 200 is formed by a rectangular portion surrounded by the extension portions 203a to 203d. The mirror portion 200 is supported by the peripheral portion 201 arranged on the left and right sides of the mirror portion 200 via the support portion 202. In other words, the mirror portion 200 is in a floating state due to the formation of the slit 203 and the recess 16, and is supported by the peripheral portion 201 with the support portions 202 on both sides acting as double-support beams. Although not shown, a metal thin film such as aluminum thin film is formed on the surface of the mirror portion 200 to form a mirror surface.

The lower electrode 13, the piezoelectric film 14 and the upper electrode 15 are formed in the peripheral portion 201 to overlap the second substrate 12 above the recess 16. The lower electrode 13 and the upper electrode 15 face each other with the piezoelectric film 14 in between. More specifically, the lower electrode 13, the piezoelectric film 14 and the upper electrode 15 are formed in a portion of the peripheral portion 201 located between the extension portion 203a and the extension portion 203b of the slit 203. The lower electrode 13 is extended onto the surface of the second substrate 12 in the outer region 21 so as to be exposed from the piezoelectric film 14, and can be electrically connected to the outside via a bonding wire or the like. Furthermore, the upper electrode 15 exposed on the piezoelectric film 14 can be electrically connected to the outside via a bonding wire or the like. The lower electrode 13 and the upper electrode 15 are electrically connected to the outside separately on either side of the mirror portion 200, so that a voltage can be applied independently. The upper electrode 15 may be extended from the end surface of the piezoelectric film 14 to the surface of the second substrate 12 at a position different from the portion from which the lower electrode 13 is extended, so that electrical connection with the outside is made at the portion on the surface of the second substrate 12.

The piezoelectric thin film device of this embodiment has such a structure. This piezoelectric thin film device is driven, for example, by electrically connecting the lower electrode 13 and the upper electrode 15 to a control circuit (not shown). When a voltage is applied between the lower electrode 13 and the upper electrode 15 on each side of the mirror portion 200 so as to generate a periodically changing potential difference, the piezoelectric film 14 is displaced by the piezoelectric effect. This causes the mirror portion 200 to swing about the support portion 202. When laser light is irradiated toward the mirror portion 200, the optical path of the reflected light changes. Based on this, a laser scan can be performed.

Although the piezoelectric thin film device differs in having a structure of a doubly supported beam, it can be manufactured through steps similar to those shown in FIGS. 3A, 3B, and 5A to 5D described in the first embodiment.

In the piezoelectric thin film device of this embodiment, if the ion implantation of the second element is not performed, warping will occur in the thin film portion 17. That is, in the peripheral portion 201, warping occurs due to a stress difference in the multi-layer film in which the lower electrode 13, the piezoelectric film 14, and the upper electrode 15 are stacked. For this reason, as in the first embodiment, for the piezoelectric thin film device of this embodiment, a piezoelectric thin film device for measuring the amount of warping is manufactured by carrying out steps similar to those shown in FIGS. 3A to 3C, the amount of warping is measured, and the manufacturing process for the piezoelectric thin film device that will become a product is carried out based on the measurement results.

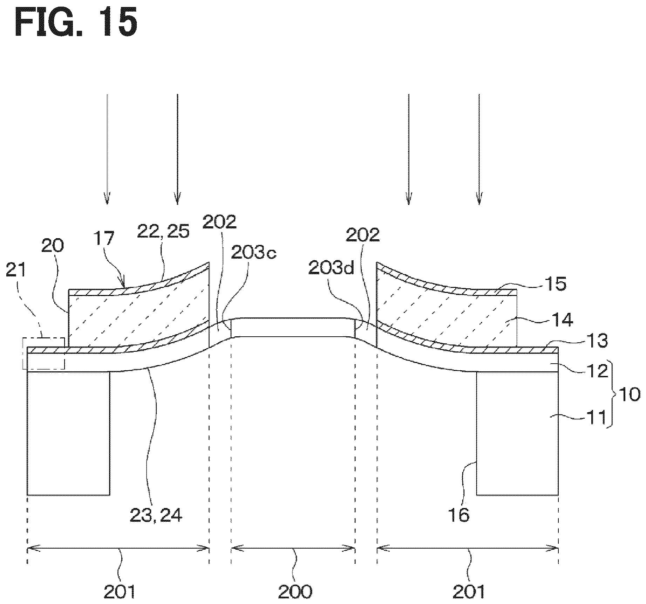

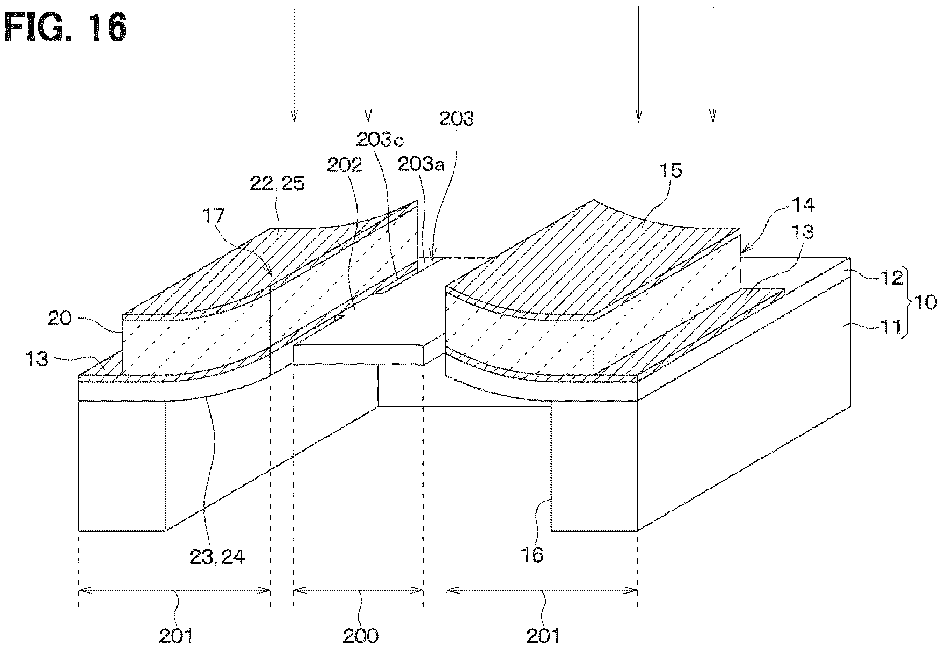

For example, suppose that a piezoelectric thin film device for measuring the amount of warping is formed by the same steps as those shown in FIGS. 3A to 3C, and warping as shown in FIG. 15 or FIG. 16 occurs. Specifically, each of the multilayer films located on both sides of the mirror portion 200 has a concave shape on the upper electrode 15, in which the inner part is recessed from the outer part, and a convex shape on the lower electrode 13, in which the inner part protrudes more than the outer part. In this case, the first surface 22 facing the upper electrode 15 is the concave surface 25, and the second surface 23 facing the lower electrode 13 is the convex surface 24.

For this reason, as in the step shown in FIG. 3C, the amount of warping is measured by measuring the height of the tip of the second surface 23 from the upper surface of the first substrate 11, or by measuring the height of one surface of the mirror portion 200 adjacent to the second surface 23 from the upper surface of the first substrate 11. When manufacturing the piezoelectric thin film device to be used as a product, the deposition conditions for forming the multilayer film are set to be the same as those for forming the multilayer film when manufacturing the piezoelectric thin film device for measuring the amount of warping. The thickness of the resist 27 formed on the upper electrode 15, etc. is adjusted in accordance with the measurement results of the amount of warping. This allows the amount of ions implanted into the impurity layer 14a to be adjusted based on the thickness of the resist 27, so that the amount of ions implanted is increased in an area with greater warping, thereby increasing the amount of correction for the area with greater warping.

This makes it possible to correct the warping of piezoelectric thin film devices individually according to the amount of warping, and makes it possible to bring the thin film portion 17 closer to a flat surface as shown in FIG. 13B and FIG. 14. Therefore, even in the piezoelectric thin film device having a double-supported beam as in this embodiment, it is possible to obtain the same effects as in the first embodiment, such as reducing the variation in the amount of warping and improving the yield.

In this embodiment, a thin metal film is formed on the surface of the mirror portion 200 as a mirror surface. In this case, the thin metal film can be applied while covering areas other than the areas to be applied with resist or the like, and then a process can be performed to remove the thin metal film on the resist together with the resist by lift-off. When the mirror surface is formed of a thin metal film, ions of the second element are implanted from the first surface 22 before the thin metal film is formed, or the thin metal film is protected by being covered with a resist or the like and then the ions are implanted. In this way, it is possible to prevent damage to the thin metal film and ensure the mirror surface.

### (Fourth Embodiment)

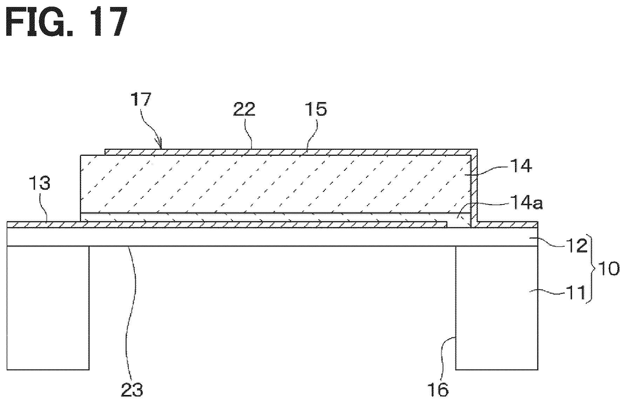

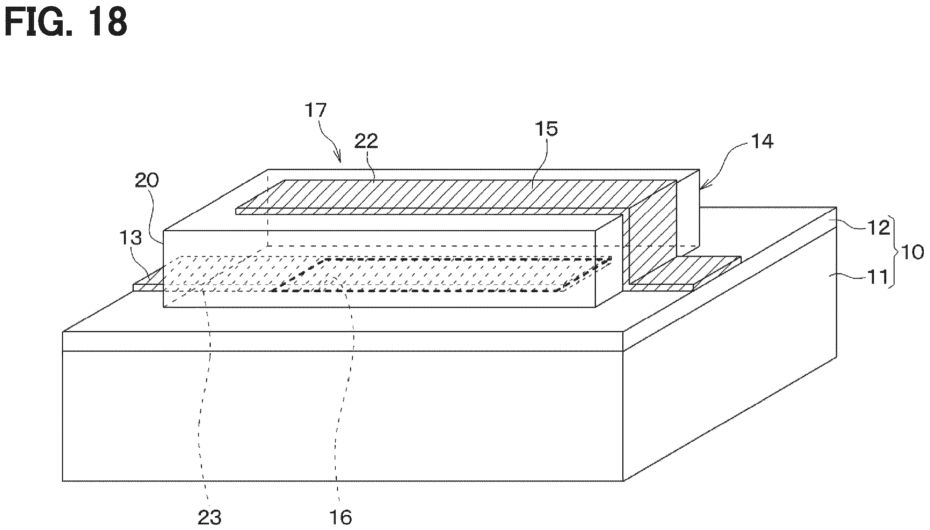

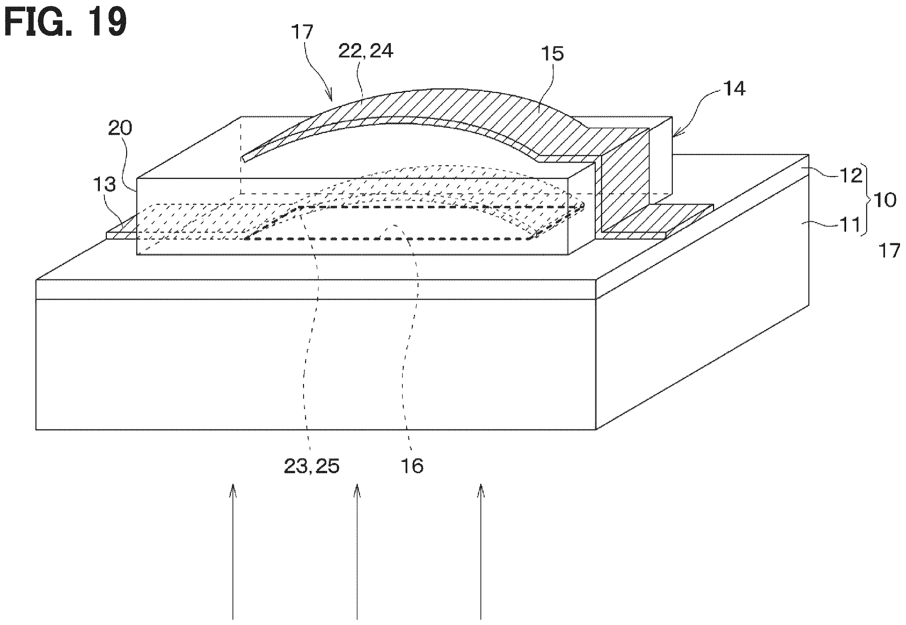

A fourth embodiment will be described. In this embodiment, the present disclosure is applied to an FBAR (short for Film Bulk Acoustic Resonator) in which a thin film portion 17 is supported all around as a piezoelectric thin film device. The basic structure of the piezoelectric thin film device of this embodiment is similar to that of the piezoelectric thin film device described in the first embodiment, so differences from the first embodiment will be mainly described. The piezoelectric thin film device of this embodiment will be described below with reference to FIGS. 17 to 19. To make FIG. 18 and FIG. 19 easier to see, the lower electrode 13 and the upper electrode 15 are hatched even in areas that are not cross-sectional.

The piezoelectric thin film device shown in FIG. 17 and FIG. 18 constitutes the FBAR. The piezoelectric thin film device has a structure in which the outer edge of the thin film portion 17 is supported by the first substrate 11 shaped like a rectangular frame having the recess 16. As shown in FIG. 17, a thin-film second substrate 12 is stacked on the first substrate 11. The lower electrode 13, the piezoelectric film 14, and the upper electrode 15 are stacked in this order on the surface of the second substrate 12. The lower electrode 13 and the upper electrode 15 are opposed to each other, above the recess 16, with the piezoelectric film 14 interposed therebetween. Furthermore, the impurity layer 14a containing the second element in addition to the first element is formed on the surface layer of the piezoelectric film 14 adjacent to the lower electrode 13.

The upper electrode 15 has a rectangular shape when viewed from the top, and is extended from the surface of the piezoelectric film 14 to the end surface and further to the surface of the second substrate 12. The upper electrode 15 can be electrically connected to the outside via a bonding wire or the like on the surface of the second substrate 12. The lower electrode 13 also has a rectangular shape when viewed from the top, and is extended to the surface of the second substrate 12 so as to be exposed from the piezoelectric film 14 on the opposite side to the upper electrode 15, and can be electrically connected to the outside via a bonding wire or the like.

A piezoelectric thin film device having such a structure is used as a filter by being connected in an electric circuit. For example, the piezoelectric effect of the piezoelectric film 14 between the lower electrode 13 and the upper electrode 15 causes the thin film portion 17 to resonate, and to extract only signals in a frequency band near the resonant frequency from signals of various frequencies flowing in an electric circuit.

The piezoelectric thin film device of this embodiment can also be manufactured through steps similar to those shown in FIGS. 3A, 3B, and 5A to 5D described in the first embodiment. In the piezoelectric thin film device of this embodiment, if the ion implantation of the second element is not performed, warping will occur in the thin film portion 17. For this reason, as in the first embodiment, for the piezoelectric thin film device having the structure of this embodiment, a piezoelectric thin film device for measuring the amount of warping is manufactured by carrying out steps similar to those shown in FIGS. 3A to 3C, the amount of warping is measured, and the manufacturing process for the piezoelectric thin film device that will become a product is carried out based on the measurement results.

For example, suppose that a piezoelectric thin film device for measuring the amount of warping is formed by the same steps as those shown in FIGS. 3A to 3C, and warping as shown in FIG. 19 occurs. Specifically, warping occurs such that the thin film portion 17 protrudes away from the first substrate 11 and is recessed when viewed from the recess 16. In this case, the first surface 22 facing the upper electrode 15 is the convex surface 24, and the second surface 23 facing the lower electrode 13 is the concave surface 25. If such warping occurs, the ion implantation of the second element will be performed on the concave side of the piezoelectric film 14. Therefore, as shown in FIG. 19, the second element will be ion-implanted from below through the recess 16 onto the second surface 23 of the thin film portion 17.

Then, as in the step shown in FIG. 3C, the height of the center of the second surface 23 from the upper surface of the first substrate 11, that is, the depth of the recess in the second surface 23, is measured to measure the amount of warping. Furthermore, when manufacturing the piezoelectric thin film device as a product, the film formation conditions for forming the multilayer film are the same as those for forming the multilayer film when manufacturing the piezoelectric thin film device for measuring the amount of warping. Furthermore, the thickness of the resist 27 formed on the surface of the second substrate 12 adjacent to the second surface 23 is adjusted in accordance with the measurement result of the amount of warping. This allows the amount of ions implanted into the impurity layer 14a to be adjusted based on the thickness of the resist 27, so that the amount of ions implanted is increased in areas with greater warping, thereby increasing the amount of correction for areas with greater warping.

This makes it possible to correct the warping of piezoelectric thin film devices individually according to the amount of warping, and makes it possible to make the thin film portion 17 closer to a flat surface as shown in FIGS. 17 and 18. Therefore, with respect to the piezoelectric thin film device constituting the FBAR as in this embodiment, it is possible to obtain the same effects as in the first embodiment, such as reducing the variation in the amount of warping and improving the yield.

In FIG. 19, the thin film portion 17 protrudes toward the opposite side to the first substrate 11, and warping occurs such that the thin film portion 17 is concave when viewed from the recess 16. That is, the first surface 22 is the convex surface 24, and the second surface 23 is the concave surface 25. The ion implantation of the second element is performed on the concave side of the piezoelectric film 14. In this embodiment, as in FIG. 19, the second element is ion-implanted from below through the recess 16 onto the second surface 23 of the thin film portion 17. Conversely, if warping occurs on the opposite side to that shown in FIG. 19, that is, in such a way that the thin film portion 17 is recessed toward the first substrate 11 to enter the recess 16, the second element can be ion-implanted onto the first surface 22 of the thin film portion 17 from above in FIG. 19, as in the first embodiment.

### (Other Embodiment)

The present disclosure is not limited to the above-described embodiment, and may be modified as appropriate within the scope of the claims. In the above embodiments, the elements constituting each embodiment are not necessarily essential unless explicitly stated as essential or clearly considered essential in principle. Further, in each of the embodiments described above, when numerical values such as the number, numerical value, quantity, range, and the like of the constituent elements of the embodiment are referred to, except in the case where the numerical values are expressly indispensable in particular, the case where the numerical values are obviously limited to a specific number in principle, and the like, the present disclosure is not limited to the specific number. Further, in each of the above-mentioned embodiments, when referring to the shape, positional relationship, and the like of a component and the like, the component is not limited to the shape, positional relationship, and the like, except for the case where the component is specifically specified, the case where the component is fundamentally limited to a specific shape, positional relationship, and the like.

As shown in FIG. 13, the present disclosure may be applied to a piezoelectric thin film device including an intermediate electrode 28. In this piezoelectric thin film device, the intermediate electrode 28 is disposed between the lower electrode 13 and the upper electrode 15. A piezoelectric film 29 serving as a first piezoelectric film is disposed between the lower electrode 13 and the intermediate electrode 28. A piezoelectric film 14 serving as a second piezoelectric film is formed between the intermediate electrode 28 and the upper electrode 15. The piezoelectric film 14 and the piezoelectric film 29 are made of a piezoelectric body. An element constituting the piezoelectric body is defined as a first element. An impurity layer 14a is formed in the surface layer of the piezoelectric film 14 close to the upper electrode 15, which contains, in addition to the first element that is a constituent element of the piezoelectric film 14, a second element that is different from the first element. The thin film portion 17 is composed of the second substrate 12, the lower electrode 13, the piezoelectric film 29, the intermediate electrode 28, the piezoelectric film 14, and the upper electrode 15. Such a piezoelectric thin film device can be used, for example, as a microphone. In other words, when pressure such as sound pressure is applied to the thin film portion 17, the thin film portion 17 vibrates. When the free end of the thin film portion 17 is displaced upward, tensile stress is generated in the piezoelectric film 29 and compressive stress is generated in the piezoelectric film 14. At this time, by measuring the voltage generated between the lower electrode 13 and the upper electrode 15, a pressure such as a sound pressure can be detected. In such a piezoelectric thin film device, the warping of the thin film portion 17 can also be corrected by forming the impurity layer 14a. Moreover, the amount of correction can be easily adjusted according to the amount of warping.

The present disclosure may be applied to piezoelectric thin film devices other than microphones. The present disclosure may also be applied to a piezoelectric thin film device in which the thin film portion 17 is supported at both ends by the first substrate 11, or to a piezoelectric thin film device in which no side surface 18 is formed and the entire upper part of the recess 16 is blocked by the thin film portion 17.

In the first embodiment, ions accelerated by a voltage in a vacuum are implanted into the piezoelectric film 14, but ion implantation may be performed by other methods. For example, ions may be implanted by applying a bias voltage to the thin film portion 17 in a vacuum.

In the first embodiment, the correction amount of warping is controlled by combining the thickness of the resist 27, the acceleration voltage, the type of the second element, etc., but the correction amount may be controlled by only some of these. In the first embodiment, conditions such as acceleration voltage are set according to the amount of warping of each piezoelectric thin film device, and ion implantation is performed individually. However, if the correction amount is controlled by the thickness of the resist 27, ions may be implanted into multiple piezoelectric thin film devices at once. That is, the spot diameter of the ion beam may be made larger than the width of one piezoelectric thin film device so that the ion beam is irradiated simultaneously onto the plural piezoelectric thin film devices.

In the first embodiment, a piezoelectric thin film device for measuring the amount of warping is manufactured before the piezoelectric thin film device to be a product. However, the piezoelectric thin film device that will become the product may be used to measure the amount of warping. For example, assume that piezoelectric thin film devices are formed on plural wafer-like semiconductor substrates 10. In this case, the steps shown in FIGS. 3A to 3C are performed on a first semiconductor substrate 10, the amount of warping is measured, and then ion implantation is performed to correct the warping. The piezoelectric thin film device formed on this semiconductor substrate 10 can be used as a product. In this ion implantation, the amount of correction can be adjusted by the dose, the acceleration voltage, or the type of the second element. For the second and subsequent semiconductor substrates 10, the ion implantation conditions are set based on the measurement results of the amount of warping in the first semiconductor substrate 10. A piezoelectric thin film device can be formed by carrying out the steps shown in FIGS. 3A, 3B, and 5A to 5D in the same manner as in the first embodiment. Furthermore, in addition to the first semiconductor substrate 10, the second and subsequent semiconductor substrates 10 may also be periodically measured for their warpage, and the manufacturing process may be carried out while updating the warpage measurement results and the ion implantation conditions. For the second and subsequent semiconductor substrates 10 whose amount of warping has been measured, similar to the first semiconductor substrate 10, ion implantation may be performed after the steps shown in FIGS. 3A to 3C and used to manufacture the piezoelectric thin film device to be a product. The measurement of the amount of warping and the update of the ion implantation conditions for the second and subsequent semiconductor substrates 10 may be performed for each of the semiconductor substrates 10 or for all of the semiconductor substrates 10.

In the third embodiment, in a piezoelectric thin film device having a support beam supported at both ends, ion implantation is performed on the first surface 22 of the thin film portion 17 adjacent to the upper electrode 15 to correct the warping. This is merely one example, and the warping can be corrected by implanting ions into the second surface 23 of the thin film portion 17 adjacent to the lower electrode 13 as in the second embodiment. That is, in the third embodiment, in the multilayer films located on both sides of the mirror portion 200, the first surface 22 becomes the concave surface 25, and the second surface 23 becomes the convex surface 24. The ion implantation of the second element is performed on the concave side of the piezoelectric film 14. Therefore, in the third embodiment, as in the first embodiment, the second element is ion-implanted on the first surface 22 of the thin film portion 17 from the upper side in FIGS. 15 and 16. Conversely, if the direction of warping of the multilayer film is reversed, in which the first surface 22 becomes the convex surface 24 and the second surface 23 becomes the concave surface 25, the ion implantation into the second surface 23 as in the second embodiment can be performed to correct the warping.

However, in case of a piezoelectric thin film device constituting a piezoelectric MEMS mirror, the second substrate 12 is made thicker, compared with the first embodiment. For this reason, when the second element is ion-implanted from the second surface 23, the amount that reaches the inside of the piezoelectric film 14 may be small, or may not reach the inside of the piezoelectric film 14 by stopping inside the second substrate 12. Even in such a case, the warping can be corrected effectively because stress is generated in the second substrate 12. However, in order to reliably inject the second element into the piezoelectric film 14 and to enhance the warping correction effect, it is advisable to adjust the film formation conditions of the multilayer film so as to achieve conditions for ion-implanting the second element from the first surface 22. If the thickness of the second substrate 12 is thin and the second element can be ion-implanted into the piezoelectric film 14 from the second surface 23, a sufficient warping correction effect can be obtained by performing the ion implantation from the second surface 23. Furthermore, even when a thin aluminum film or the like constituting a mirror surface is formed on the surface of the mirror portion 200, there is no need to worry about damaging the mirror surface if the second element is ion-implanted from the second surface 23. In that case, the ion implantation may be performed after the formation of the thin aluminum film or the like.

### (Characteristics of present disclosure)

### [Aspect 1]

A piezoelectric thin film device includes:
a substrate (10);
a lower electrode (13) stacked on the substrate;
a piezoelectric film (14) made of a piezoelectric body and stacked on the lower electrode; and
an upper electrode (15) stacked on the piezoelectric film.

A thin film portion (17) including the lower electrode, the piezoelectric film, and the upper electrode is formed by a recess (16) formed in the substrate opposite to the lower electrode.

An element constituting the piezoelectric body is a first element.

An impurity layer (14a) is formed in the piezoelectric film to contain, in addition to the first element, a second element different from the first element.

### [Aspect 2]

In the piezoelectric thin film device according to Aspect 1, the impurity layer is formed in a surface layer of the piezoelectric film adjacent to the upper electrode.

### [Aspect 3]

In the piezoelectric thin film device according to Aspect 1, the impurity layer is formed in a surface layer of the piezoelectric film adjacent to the lower electrode.

### [Aspect 4]

In the piezoelectric thin film device according to any one of Aspects 1 to 3, the impurity layer contains more voids or amorphous layers than a portion of the piezoelectric film that is different from the impurity layer.

### [Aspect 5]

In the piezoelectric thin film device according to any one of Aspects 1 to 4, the thin film portion has a first surface (22) located on the same side as the upper electrode with respect to the piezoelectric film, and a second surface (23) located on the same side as the lower electrode with respect to the piezoelectric film, and
one of the first surface and the second surface closer to the impurity layer has a surface roughness greater than that of the other.

### [Aspect 6]

A manufacturing method of a piezoelectric thin film device includes:
forming a lower electrode (13) on an upper surface of a substrate (10);
forming a piezoelectric film (14) made of a piezoelectric body on an upper surface of the lower electrode;
forming an upper electrode (15) on an upper surface of the piezoelectric film;
forming a recess (16) in the substrate opposite to the lower electrode to form a thin film portion (17) including the lower electrode, the piezoelectric film, and the upper electrode; and
forming an impurity layer (14a) in the piezoelectric film, to contain a second element that is different from the first element, in addition to the first element that constitutes the piezoelectric body.

### [Aspect 7]

In the manufacturing method according to Aspect 6, when a warping occurs in the thin film portion, the thin film portion has a convex surface (24) convex toward outside, and a concave surface (25) concave to the opposite side opposite to the convex surface, and
in the forming of the impurity layer, the impurity layer is formed in a surface layer of the piezoelectric film adjacent to the concave surface.

### [Aspect 8]

In the manufacturing method according to Aspect 6 or 7, in the forming of the impurity layer, the second element is selected depending on a magnitude of the warping generated in the thin film portion.

### [Aspect 9]

In the manufacturing method according to any one of Aspects 6 to 8, in the forming of the impurity layer, an ionized second element is accelerated by a voltage and injected into the piezoelectric film.

### [Aspect 10]

In the manufacturing method according to any one of Aspect 6 to 9, in the forming of the impurity layer,
applying a resist (27) to an upper part of the substrate;
changing a thickness of the resist depending on a location according to a magnitude of the warping generated in the thin film portion; and
introducing the second element into the piezoelectric film by using the resist.

### [Aspect 11]

In the manufacturing method according to Aspect 10, in the forming of the impurity layer, a thickness of the resist is controlled by an exposure device.

## Claims

1. A piezoelectric thin film device comprising:
a substrate (10);
a lower electrode (13) stacked on the substrate;
a piezoelectric film (14) made of a piezoelectric body and stacked on the lower electrode; and
an upper electrode (15) stacked on the piezoelectric film, wherein
a recess (16) is formed in the substrate opposite to the lower electrode such that a thin film portion (17) is formed to include the lower electrode, the piezoelectric film, and the upper electrode,
an element forming the piezoelectric body is a first element, and
an impurity layer (14a) is formed in the piezoelectric film to contain, in addition to the first element, a second element different from the first element.

2. The piezoelectric thin film device according to claim 1, wherein the impurity layer is formed in a surface layer of the piezoelectric film adjacent to the upper electrode.

3. The piezoelectric thin film device according to claim 1, wherein the impurity layer is formed in a surface layer of the piezoelectric film adjacent to the lower electrode.

4. The piezoelectric thin film device according to any one of claims 1 to 3, wherein the impurity layer contains more voids or amorphous layers than a portion of the piezoelectric film other than the impurity layer.

5. The piezoelectric thin film device according to any one of claims 1 to 3, wherein
the thin film portion has a first surface (22) located on the same side as the upper electrode with respect to the piezoelectric film, and a second surface (23) located on the same side as the lower electrode with respect to the piezoelectric film, and
one of the first surface and the second surface, which is closer to the impurity layer, has a surface roughness greater than that of the other of the first surface and the second surface.

6. A manufacturing method of a piezoelectric thin film device comprising:
forming a lower electrode (13) on an upper surface of a substrate (10);
forming a piezoelectric film (14) made of a piezoelectric body on an upper surface of the lower electrode;
forming an upper electrode (15) on an upper surface of the piezoelectric film;
forming a recess (16) in the substrate opposite to the lower electrode to form a thin film portion (17) including the lower electrode, the piezoelectric film, and the upper electrode; and
forming an impurity layer (14a) in the piezoelectric film to contain a first element and a second element that is different from the first element, wherein the piezoelectric body is formed of the first element.

7. The manufacturing method according to claim 6, wherein
the thin film portion has a convex surface (24) convex toward outside and a concave surface (25) concave to a side opposite to the convex surface when a warping occurs in the thin film portion, and
the impurity layer is formed in a surface portion of the piezoelectric film adjacent to the concave surface.

8. The manufacturing method according to claim 6 or 7, wherein the second element is selected depending on a magnitude of the warping, when the warping occurs in the thin film portion, in the forming of the impurity layer.

9. The manufacturing method according to claim 6 or 7, wherein an ionized second element is accelerated by a voltage and injected into the piezoelectric film, in the forming of the impurity layer.

10. The manufacturing method according to claim 6 or 7, wherein in the forming of the impurity layer,
applying a resist (27) to an upper part of the substrate;
changing a thickness of the resist depending on a location according to a magnitude of the warping in a respective thin film portion when the warping occurs in the thin film portion; and
introducing the second element into the piezoelectric film by using the resist.

11. The manufacturing method according to claim 10, wherein a thickness of the resist is controlled by an exposure device, in the forming of the impurity layer.
